(19)

Europäisches Patentamt
European Patent Office
Office européen des brevets

(11) **EP 3 563 984 A1**

(12) **EUROPEAN PATENT APPLICATION**
published in accordance with Art. 153(4) EPC

(43) Date of publication:
**06.11.2019 Bulletin 2019/45**

(21) Application number: **17887993.8**

(22) Date of filing: **09.03.2017**

(51) Int Cl.:
**B25J 9/22** *(2006.01)*    **B25J 15/06** *(2006.01)*

(86) International application number:
**PCT/JP2017/009600**

(87) International publication number:
**WO 2018/123087 (05.07.2018 Gazette 2018/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **28.12.2016 JP 2016255408**

(71) Applicant: **Omron Corporation**
**Kyoto-shi, Kyoto 600-8530 (JP)**

(72) Inventors:
- **MORIYA, Toshihiro**
  **Kyoto-shi**
  **Kyoto 600-8530 (JP)**
- **KARAKO, Yukihisa**
  **Kyoto-shi**
  **Kyoto 600-8530 (JP)**
- **ABE, Masayoshi**
  **Kyoto-shi**
  **Kyoto 600-8530 (JP)**
- **TSUTSUMI, Yumi**
  **Kyoto-shi**
  **Kyoto 600-8530 (JP)**

(74) Representative: **Horn Kleimann Waitzhofer**
**Patentanwälte PartG mbB**
**Ganghoferstrasse 29a**
**80339 München (DE)**

(54) **SIMULATION DEVICE, ROBOT, SIMULATION METHOD, AND PROGRAM**

(57) Provided is a simulation technique for easily and accurately simulating a holding operation of an apparatus that holds a workpiece. A motion instruction value calculation unit 130 is configured to calculate operation instruction values of a pick-and-place apparatus to be simulated. A dynamics calculation unit 160 is configured to read the operation instruction values that are output from the motion instruction value calculation unit 130, and to calculates an apparatus operation considering the dynamics. Based on the apparatus operation considering the dynamics, the suction success/failure calculation unit 170 is configured to determine whether a workpiece is successfully sucked by a suction pad. A 3D display unit 190 is configured to display a 3D image of the apparatus operation considering the dynamics in a display unit such as a liquid crystal display.

**FIG. 2**

EP 3 563 984 A1

**Description**

CROSS REFERENCE TO RELATED APPLICATION

This application claims priority to Japanese Patent Application No. 2016-255408 filed December 28, 2016, the entire contents of which are incorporated herein by reference.

TECHNICAL FIELD

The present invention relates to a simulation technique for simulating the operation of an apparatus that holds a workpiece.

BACKGROUND ART

In general, in a manufacturing line or the like of a factory, a pick-and-place apparatus is used as an apparatus that holds parts and products (hereinafter collectively referred to as "workpieces") and transports them to other places. In many cases, a holding apparatus having a suction pad or chuck is used as a holding unit for holding parts. However, in the pick-and-place apparatus, an operator or the like of the manufacturing line adjusts the apparatus by trial and error while actually operating the apparatus so that the optimum operation is performed.

However, with the method of actually operating and adjusting the apparatus, adjustment cannot be implemented unless the actual apparatus has been completed, or even if there is already an actual apparatus in the production line, it is necessary to interrupt the original work of the pick-and-place apparatus for adjustment work and to stop the line. Therefore, there is a problem that production efficiency deteriorates.

As one method for solving such a problem, a simulation method for a robot that transports workpieces has been proposed that is capable of creating an operation program for the robot on an image output apparatus including a display panel or the like (see Patent Document 1, for example).

RELATED ART DOCUMENT

PATENT DOCUMENT

Patent Document 1: JP H07-256578A

SUMMARY OF THE INVENTION

However, in the above conventional simulation method, the vibration acceleration is merely estimated or the like using the operation speed of the robot as a parameter, and it is only possible to determine the maximum operating speed at which the robot can operate at the designated vibration acceleration by confirming the vibrations obtained through the simulation. Therefore, there has been a problem that it cannot simulate whether the robot can hold a workpiece.

The present invention has been made in view of the above-mentioned circumstances, and it is an object of the present invention to provide a simulation technique for easily and accurately simulating a holding operation of an apparatus that holds a workpiece.

A simulation apparatus according to one aspect of the present invention is a simulation apparatus configured to simulate whether an article can be held by a holding unit with which a robot is provided, the apparatus includes a holding success/failure determination unit configured to determine whether the holding unit can hold the article, based on an operation instruction value of the holding unit that is calculated based on moving speed or acceleration of the holding unit and a moving path of the holding unit, and the mass of the article.

With the above configuration, because it is simulated whether the holding unit can hold the article based on the operation instruction value of the holding unit provided in the robot and the mass of the article, it is possible to easily and accurately simulate the holding operation of the robot.

In the above aspect, a configuration may also be employed in which the simulation apparatus further includes an instruction value calculation unit configured to calculate an operation instruction value of the holding unit based on the moving speed or the acceleration of the holding unit and the moving path of the holding unit, and a holding force calculation unit configured to calculate, from the operation instruction value and the mass of the article, a holding force with which the holding unit holds the article when the holding unit operates in accordance with the operation instruction value, and the holding success/failure determination unit is configured to determine whether the holding unit can hold the article based on the holding force.

In the above configuration, a configuration may also be employed in which the holding force calculation unit is configured to calculate the holding force with which the holding unit holds the article, considering a motion of rotation about the horizontal or vertical direction with respect to the transportation surface of the article.

In the above configuration, a configuration may also be employed in which the holding force calculation unit is configured to calculate an oscillation amplitude of the article based on the operation instruction value and the mass of the article, and the holding success/failure determination unit is configured to determine, based on a result of comparison between the calculated oscillation amplitude of the article and a predetermined threshold value, whether the holding unit can hold the article.

In the above configuration, a configuration may also be employed in which the simulation apparatus further includes a first display unit configured to display the oscillation amplitude of the article.

In the above configuration, a configuration may also be employed in which the simulation apparatus further includes a second display unit configured to display an image simulating success or failure of holding of the article by the holding unit, and the display color of the article that is displayed in the second display unit is changed based on the holding force with which the holding unit holds the article.

In the above configuration, a configuration may also be employed in which the simulation apparatus is configured to receive a change of moving speed or acceleration of the holding unit, and the holding success/failure determination unit is configured to determine again, based on the received moving speed or acceleration of the holding unit after the change, whether the holding unit can hold the article.

In the above configuration, the holding unit may also be a suction pad that holds the article by suction.

In the above configuration, a configuration may also be employed in which the holding force calculation unit is configured to calculate a holding force with which the holding unit holds the article, considering a suctional force with which the suction pad sucks the article and a normal force at a contact surface between the suction pad and the article.

In the above configuration, a configuration may also be employed in which the holding success/failure determination unit is configured to determine that the article cannot be held when the normal force at the contact surface between the suction pad and the article becomes zero, and the simulation apparatus further includes a correction receiving unit configured to receive a correction of the moving speed or the acceleration in the direction in which the suction pad operates at that time.

In the above configuration, a configuration may also be employed in which the holding force calculation unit is configured to also calculate a suction frictional force generated between the suction pad and the article.

In the above configuration, a configuration may also be employed in which the holding force calculation unit is configured to calculate the normal force also considering the ambient outside pressure in which the robot operates.

In the above configuration, a configuration may also be employed in which the holding success/failure determination unit is configured to determine that the article cannot be held when the normal force at the contact surface between the suction pad and the article becomes zero, and the simulation apparatus further includes a suction pad change receiving unit configured to receive a change of the diameter of the suction pad or the number of the suction pads.

In the above configuration, the holding unit may also be a grasping-type holding unit configured to hold the article with claws.

In the above configuration, a configuration may also be employed in which the holding force calculation unit is configured to calculate a force with which the holding unit holds the article, considering grasping power with which the article is grasped by the claws and a frictional force at a contact surface between the claws and the article.

A simulation method according to another embodiment of the present invention is a simulation method for simulating whether a holding unit with which a robot is provided can hold an article, the method includes a holding success/failure determination step of determining whether the holding unit can hold the article based on an operation instruction value of the holding unit that is calculated based on moving speed or acceleration of the holding unit and a moving path of the holding unit, and the mass of the article.

A simulation program according to the other aspect is a simulation program for causing a computer to execute simulation for determining whether a holding unit with which a robot is provided can hold an article, and the program causes the computer to execute a holding success/failure determination step of determining whether the holding unit can hold the article based on an operation instruction value of the holding unit that is calculated based on moving speed or acceleration of the holding unit and a moving path of the holding unit, and the mass of the article.

A robot according to the other aspect of the present invention is a robot provided with a simulation function for simulating whether an article can be held by a holding unit provided in the robot, the robot including a holding success/failure determination unit configured to determine whether the holding unit can hold the article, based on an operation instruction value of the holding unit that is calculated based on moving speed or acceleration of the holding unit and a moving path of the holding unit, and the mass of the article.

EFFECTS OF THE INVENTION

According to the present invention, it is possible to provide a technique for easily and accurately simulating the holding operation of an apparatus that holds a workpiece.

BRIEF DESCRIPTION OF THE DRAWINGS

Fig. 1      is a diagram showing a hardware configuration of a simulation apparatus according to the present embodiment.
Fig. 2      is a block diagram showing a first functional configuration of the simulation apparatus.
Fig. 3      is a flowchart showing the outline of simulation operation.
Fig. 4      is a diagram illustrating a motion program and motion parameters.
Fig. 5      is a drawing illustrating physical models of a holding unit and a workpiece in a pick-and-place apparatus.
Fig. 6      is a diagram showing a condition for determining success or failure of suction of a workpiece.
Fig. 7      is a diagram showing the condition for determining success or failure of suction of the workpiece.
Fig. 8A     is a drawing illustrating a simulation image showing successful suction of the workpiece.
Fig. 8B     is a drawing illustrating a simulation image showing failed suction of the workpiece.
Fig. 9      is a flowchart showing a parameter correction process (1).
Fig. 10     is a flowchart showing a parameter correction process (2).
Fig. 11     is a block diagram showing a second functional configuration of the simulation apparatus.
Fig. 12     is a flowchart showing the outline of a simulation operation.
Fig. 13A    is a drawing illustrating physical models of a holding unit and a workpiece according to a first variation.
Fig. 13B    is a drawing illustrating the physical models of the holding unit and the workpiece according to the first variation.
Fig. 14     is a drawing illustrating an investigation result table showing the result of an investigation for determining whether a workpiece falls.
Fig. 15     is a drawing illustrating an investigation reflection graph.
Fig. 16     is a drawing illustrating the investigation reflection graph.

EMBODIMENTS OF THE INVENTION

Hereinafter, an embodiment of the present invention will be described with reference to the figures. Note, that the same elements are denoted by the same reference numerals, and duplicate descriptions will be omitted. The following embodiments are examples for explaining the present invention, and are not intended to restrict the present invention only to the embodiments. Furthermore, the present invention can be modified without departing from the essence thereof.

A. Embodiment

1. Configuration

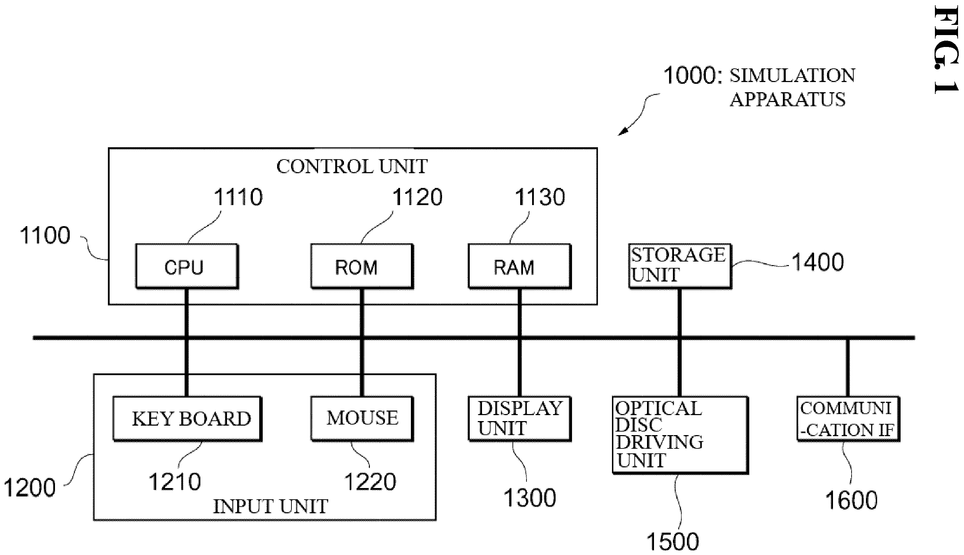

Fig. 1 is a diagram showing a hardware configuration of a simulation apparatus 1000 according to the present embodiment. The simulation apparatus 1000 is an apparatus for simulating, for example, whether a pick-and-place apparatus (a robot) can normally hold (including transporting) a workpiece, and is constituted by, for example, a personal computer (PC) or a workstation. As shown in Fig. 1, similar to ordinary PCs, the simulation apparatus 1000 includes a control unit 1100, an input unit 1200, a display unit 1300, a storage unit 1400, an optical disc driving unit 1500, and a communication interface 1600.

The control unit 1100 has a function for centrally controlling the simulation apparatus 1000, and includes a CPU (Central Processing Unit) 1110, a ROM (Read Only Memory) 1120, and a RAM (Random Access Memory) 1130. The CPU 1110 performs various processes described later based on data and programs stored in the ROM 1120 and the RAM 1130, and also controls the units of the simulation apparatus 1000.

The input unit 1200 includes various operation buttons and a numeric keypad, in addition to a keyboard 1210 and a mouse 1220, and is used for inputting various commands and data to the simulation apparatus 1000.

The display unit 1300 includes a monitor such as a liquid crystal display, and is used for displaying a simulation result and the like.

The storage unit 1400 is constituted by various types of storage apparatuses such as a hard disc drive (HDD) and a flash memory. Under the control of the control unit 1100, the optical disc driving unit 1500 reads data stored in various disc media (e.g., CD-ROM, Blu-ray disc, or the like), writes data to the disc media, and the like. The communication interface 1600 is used for transmitting and receiving data to and from an external apparatus through various communication methods (e.g., wired communication, wireless communication, or the like). Note, that the simulating function according to the simulation apparatus 1000 may also be directly installed in the pick-and-place apparatus.

2. Functions

2-1. First functional configuration (in case where motion parameters are automatically corrected)

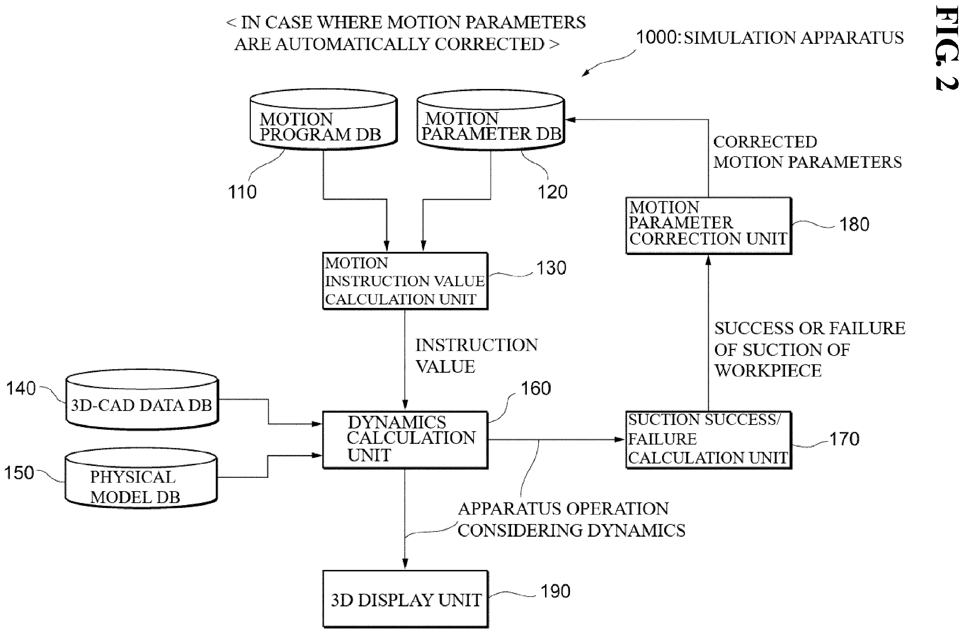

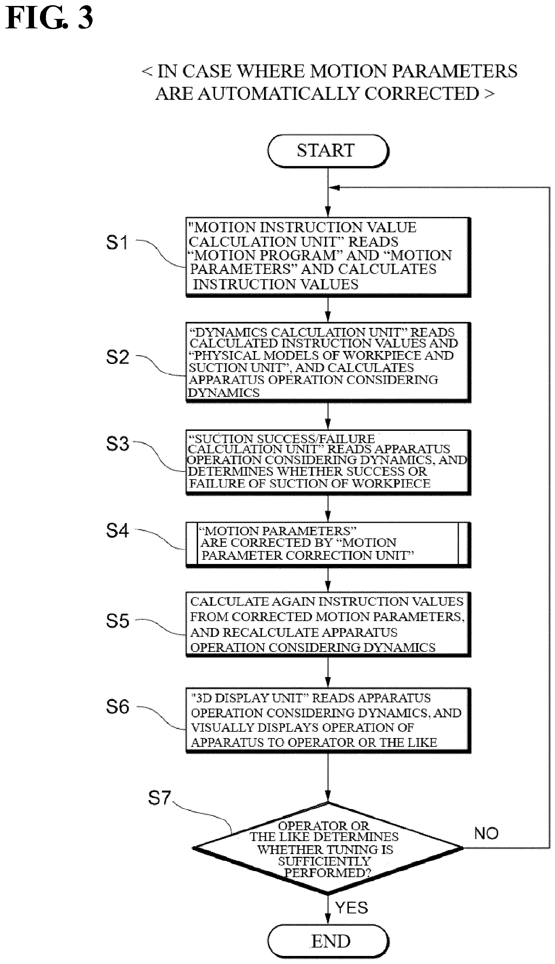

Here, Fig. 2 is a block diagram showing a first functional configuration of the simulation apparatus 1000, and Fig. 3 is a flowchart showing an outline of the simulation operation performed by the simulation apparatus 1000. The simulation apparatus 1000 realizes the following units by the software stored in memories such as the ROM 1120 and the RAM 1130 cooperating with the hardware resources (e.g., the CPU 1110 and the like). Note, that in the present embodiment, the operation of the pick-and-place apparatus provided with a suction pad serving as holding means for holding workpieces such as parts and products is to be simulated. However, as described later, the operation of a pick-and-place apparatus provided with a chuck instead of the suction pad may also be simulated. Also, in the first functional configuration described below, it is assumed that the motion parameters of the pick-and-place apparatus are automatically corrected depending on the result of success or failure of suction of a workpiece. As will be described in detail later, the motion parameters include various parameters regarding the movement of the holding unit, such as information representing the movement path of the holding unit of the pick-and-place apparatus, information representing the moving speed (e.g., maximum speed) of the holding unit, and information representing the acceleration (e.g., maximum acceleration) of the holding unit.

As shown in Fig. 2, the simulation apparatus 1000 includes a motion program DB (database) 110, a motion parameter DB 120, a motion instruction value calculation unit 130, a 3D-CAD data DB 140, a physical model DB 150, a dynamics calculation unit 160, a suction success/failure calculation unit 170, a motion parameter correction unit 180, and a 3D display unit 190.

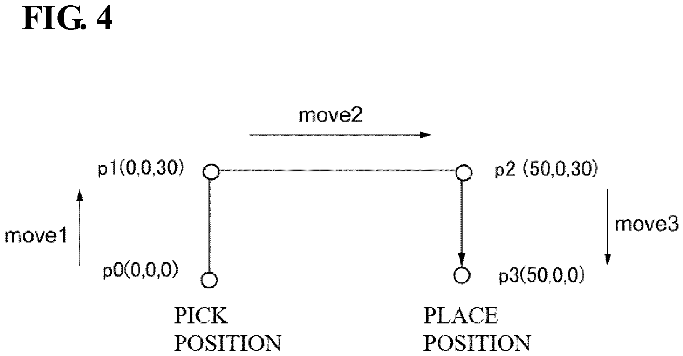

Fig. 4 is a diagram illustrating a motion program and motion parameters.

In the example shown in Fig. 4, it is assumed that the holding unit of the pick-and-place apparatus that is holding a workpiece is moved from the coordinate p0 (0,0,0) at which the workpiece is picked up to the coordinate p3 (50, 0,0) at which the workpiece is placed down via the coordinates p1 (0, 0, 30) and p2 (50,0,30) (the units of the coordinate positions are assumed to be given, for example, in cm).

The motion program is a program that instructs the movement of the holding unit of the pick-and-place apparatus, and includes three linear interpolation "move" commands as shown in Table 1 in the example shown in Fig. 4.

Table 1

| <Motion program> | |
| --- | --- |
| Row number | Command |
| 1 | Move move 1; |
| 2 | Move move 2; |
| 3 | Move move 3; |

On the other hand, the motion parameters are constituted by, for example, a target position (moving path), maximum speed, maximum acceleration, and maximum deceleration of the holding unit of the pick-and-place apparatus. In the example shown in Fig. 4, motion parameters as shown in Table 2 are set for each command "move". Here, in Table 2, a case is illustrated in which the ratios to the standard speed, to the standard maximum acceleration, and to the standard maximum deceleration set for a given pick-and-place apparatus are specified (specified as percent), but the present embodiment is not limited to this. The maximum speed, the maximum acceleration, and the maximum deceleration constituting the motion parameters may also be specified as absolute values.

Table 2

| <Motion parameters> | | | | |
| --- | --- | --- | --- | --- |
| Command | Target position | Maximum speed [%] | Maximum acceleration [%] | Maximum deceleration [%] |
| move1 | p1 (0,0,30) | 100 | 100 | 100 |

(continued)

| <Motion parameters> | | | | |
| --- | --- | --- | --- | --- |
| Command | Target position | Maximum speed [%] | Maximum acceleration [%] | Maximum deceleration [%] |
| move2 | p2 (50,0,30) | 100 | 100 | 100 |
| move3 | p3 (50,0,0) | 100 | 100 | 100 |

Regarding the operation of the pick-and-place apparatus that is to be simulated, if a command for transporting a workpiece is input, the motion instruction value calculation unit (the instruction value calculation unit) 130 reads the motion program shown in Table 1 from the motion program DB 110, and also reads the motion parameters shown in Table 2 from the motion parameter DB 120 to calculate the operation instruction values (see step S1 shown in Fig. 3).

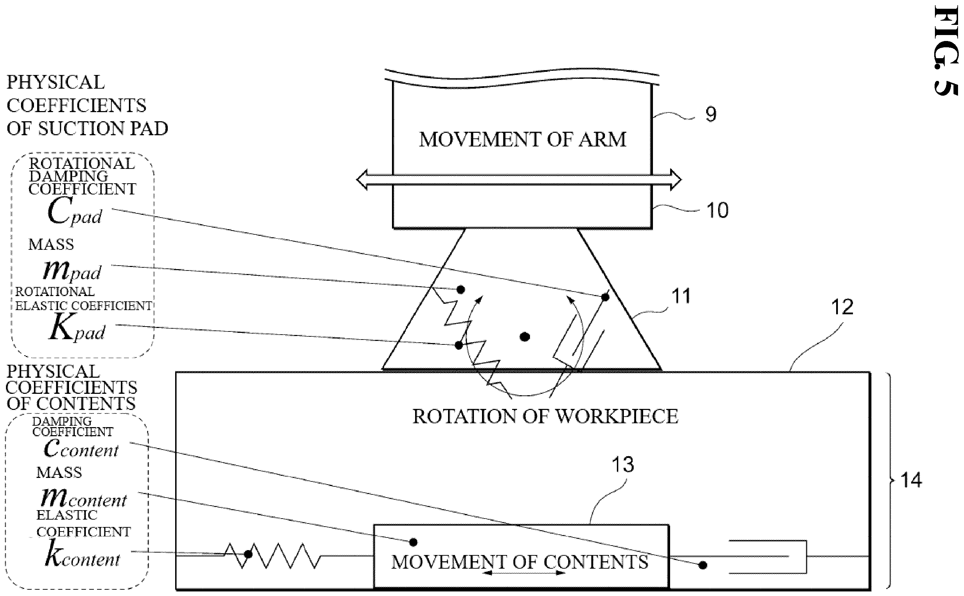

Here, Fig. 5 is a diagram illustrating physical models of the holding unit of the pick-and-place apparatus and the workpiece.

The holding unit of the pick-and-place apparatus includes an apparatus tip (front end) portion 10 and a suction pad 11 provided at the end portion of an arm 9. A workpiece 14, which is moved by the holding unit of the pick-and-place apparatus, includes a container 12 and contents 13.

In the physical model DB 150, data for specifying the physical models of the workpiece and the holding unit of the pick-and-place apparatus (hereinafter abbreviated as "physical models of the workpiece and the holding unit") is registered. In the example shown in Fig. 5, as physical coefficients of the suction pad 11, a rotational damping coefficient Cpad, the mass mpad, and a rotational elastic coefficient Kpad are specified. Also, as physical coefficients of the contents 13, a damping coefficient Ccontent, the mass mcontent, and an elastic coefficient kcontent and the like are specified.

The dynamics calculation unit (holding force calculation unit) 160 reads operation instruction values output from the motion instruction value calculation unit 130 and physical models of the workpiece and the holding unit from the physical model DB 150, and calculates various data regarding the operation of the workpiece and the holding unit considering the dynamics (hereinafter abbreviated as "apparatus operation considering the dynamics") (see step S2 shown in Fig. 3). At this time, the dynamics calculation unit 160 calculates the apparatus operation (e.g., the holding force or the like for holding a workpiece) in view of the dynamics in consideration of the motion of rotation about the horizontal direction or the vertical direction with respect to the transportation surface of the workpiece. Here, the transportation surface is the surface of the workpiece 14 that is sucked by the suction pad 11, and means the surface of the workpiece 14 extending along the movement direction of the arm 9 (see Fig. 5). The dynamics calculation unit 160 outputs the apparatus operation considering the dynamics to the suction success/failure calculation unit 170 and the 3D display unit 190.

Based on the apparatus operation considering the dynamics that is supplied from the dynamics calculation unit 160, the suction success/failure calculation unit (the holding force calculation unit and the holding success/failure determination unit) 170 determines whether the suction pad 11 has successfully sucked the workpiece (see step S3 shown in Fig. 3), and outputs the determination result information representing the determination result to the motion parameter correction unit 180.

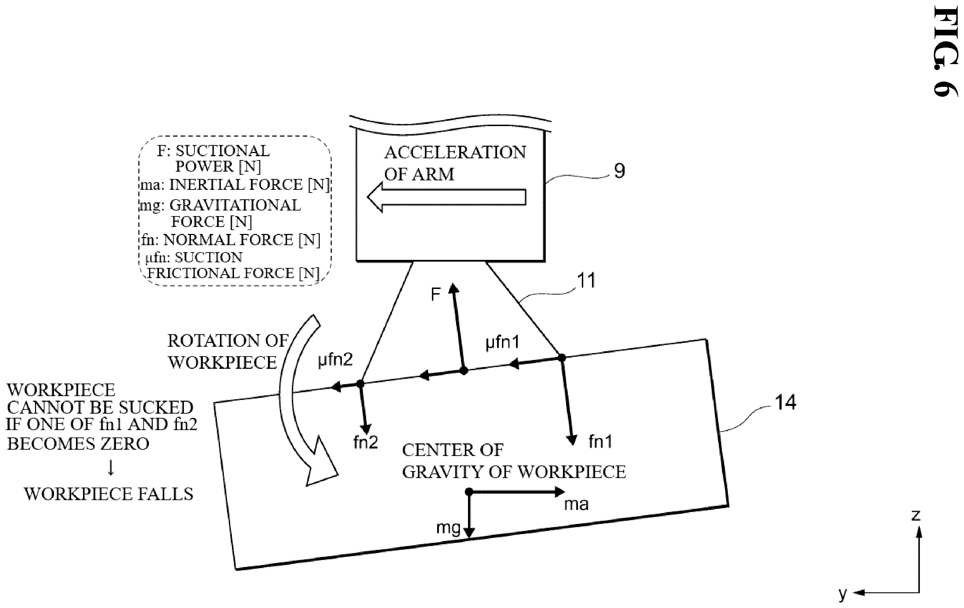

Fig. 6 is a diagram illustrating the condition for determining whether the workpiece has successfully sucked. The mass m of the workpiece, the suctional force F (N), the inertial force ma (N), the gravitational force mg (N), the normal force fn (N), and the suction frictional force $\mu$fn (N) are shown in Fig. 6. In the example shown in Fig. 6, the suction success/failure calculation unit 170 determines that the suction of the workpiece failed if one of the normal force fn1 and normal force fn2 becomes zero. Otherwise (that is, if both of the normal force fn1 and the normal force fn2 are larger than zero), the suction success/failure calculation unit 170 determines that the suction of the workpiece has succeeded. In the present embodiment, the "suction of a workpiece" refers to a series of motions in which a workpiece is held by the pick-and-place apparatus and transported to its destination. Note, that successful suction of a workpiece means that the workpiece is transported to its destination in a normal state. On the other hand, the failed suction of a workpiece may mean that the workpiece falls while being transferred to its destination, or that the workpiece is transported in an abnormal state (the workpiece greatly vibrates, for example). When the normal force fn1 and the normal force fn2 are obtained, the surrounding environment where the pick-and-place apparatus is installed (for example, the ambient outside pressure) may also be taken into consideration.

However, the condition for determining whether a workpiece has been successfully sucked is not limited to the condition shown in Fig. 6. A falling limit threshold value fth may be set for the normal force fn, for example, and it may also be determined that the workpiece cannot be sucked if the normal force fn becomes lower than the falling limit threshold value fth.

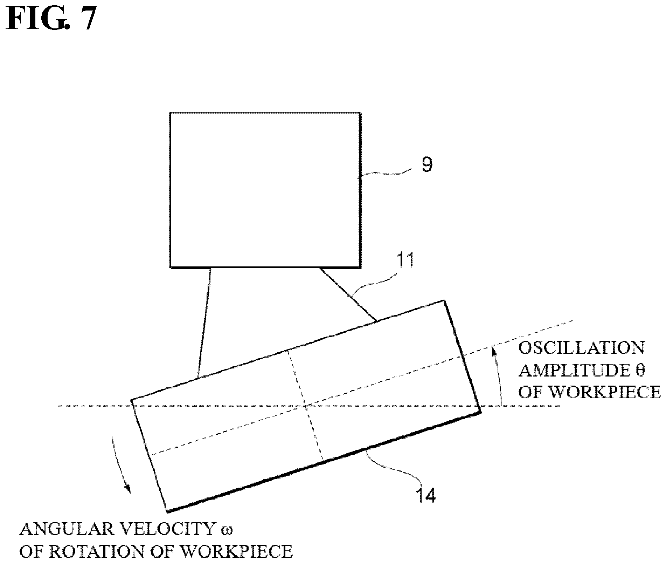

Furthermore, as a determination condition for easily determining whether a workpiece is successfully sucked, as shown in Fig. 7, for example, the suction success/failure calculation unit 170 may also determine that the workpiece 14 falls if the oscillation amplitude θ of the workpiece 14 is larger than or equal to a certain value (larger than or equal to a specified threshold value), or determine that the workpiece 14 falls if the angular velocity ω of the rotation of the workpiece 14 is larger than or equal to a fixed value. In addition, the suction success/failure calculation unit 170 may also determine that the workpiece 14 falls if angular acceleration ω' (not shown) of the rotation of the workpiece 14 is larger than or equal to a certain value. Needless to say, the conditions under which the workpiece 14 falls may also be set by combining these conditions as appropriate. Furthermore, "workpiece 14" in these conditions may be replaced with "suction pad 11", and it may also be determined that the workpiece 14 falls if the oscillation amplitude θ or the like of the suction pad 11 is larger than or equal to a certain value. Note, that the dynamics calculation unit 160 can calculate the oscillation amplitude θ or the like of the workpiece 14 using the operation instruction values, the mass of the workpiece, and the like.

Referring to Fig. 2 again, the motion parameter correction unit 180 corrects the motion parameters of the pick-and-place apparatus based on the determination result information that is provided from the suction success/failure calculation unit 170 (see step S4 shown in Fig. 3), and updates the registered contents of the motion parameter DB 120 based on the corrected motion parameters. Specific correction methods and the like of the motion parameters will be described later, and the overall operation flow will be described next.

The motion instruction value calculation unit 130 reads the corrected motion parameters from the motion parameter DB 120, calculates the operation instruction values again, and outputs the operation instruction values that were calculated again to the dynamics calculation unit 160. The dynamics calculation unit (the holding force calculation unit) 160 recalculates the apparatus operation considering the dynamics based on the operation instruction values (see step S5 shown in Fig. 3), and outputs the recalculated apparatus operation considering the dynamics to the suction success/failure calculation unit 170 and the 3D display unit 190.

The 3D display unit 190 displays a 3D image of the calculated apparatus operation considering the dynamics and the recalculated apparatus operation considering the dynamics in the display unit (the first display unit or the second display unit) such as a liquid crystal panel (see step S6 shown in Fig. 3) to cause the operator or the like to recognize the operation simulation of the pick-and-place apparatus. The 3D display unit 190 obtains CAD data or the like of the pick-and-place apparatus from the 3D-CAD database 140, and displays the above 3D image in the display unit. Note, that instead of (or, in addition to) displaying the 3D image of the apparatus operation considering the dynamics, a 2D image thereof may also be displayed, or the numerical values thereof may also be displayed. Furthermore, any mode may also be used as long as the apparatus operation considering the dynamics is recognized by the operator or the like.

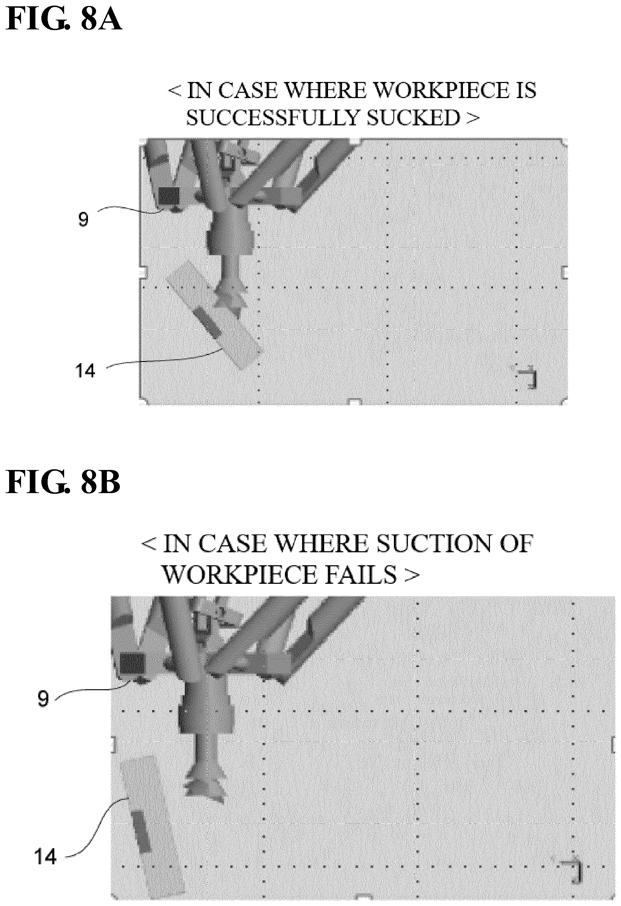

Fig. 8 is a drawing illustrating an image (simulation image) in which the success or failure of suction of a workpiece is simulated. Fig. 8A shows an example of successful suction of a workpiece, and Fig. 8B shows an example of failed suction of a workpiece.

The operator or the like confirms the simulation image, determines whether the suction operation of the workpiece by the pick-and-place apparatus has been sufficiently adjusted (tuned), and performs an input operation indicating whether the adjustment has been sufficiently made (see step S7 shown in Fig. 3). If the operator or the like determines that the adjustment has not been sufficiently made because of the failed suction of the workpiece (NO in step S7 shown in Fig. 3), the operator or the like operates the operation buttons or the like, and makes an input for continuing the automatic correction process of the motion parameters. If such an operation is made, the simulation apparatus 1000 returns to step S1, and continues the series of processes of steps S1 to S7 that are described above.

On the other hand, if the operator or the like determines that the adjustment was sufficient because of the successful suction of the workpiece (YES in step S7 shown in Fig. 3), the operator or the like operates the operation buttons or the like and ends the automatic correction process of the motion parameters. Note, that when an image in which the success or failure of suction of the workpiece is simulated is displayed in the display unit, the display color of the workpiece may also be changed based on the holding force for holding the workpiece. If the workpiece has been successfully sucked and the force for holding the workpiece is sufficiently large, for example, the workpiece is displayed in blue. On the other hand, if the workpiece has been successfully sucked, but the force for holding the workpiece is weak, the workpiece is shown in yellow to call this to the attention of the operator or the like. Furthermore, if the suction of the workpiece fails, the workpiece is displayed in red so that the operator or the like can recognize at a glance that the force for holding the workpiece is weak. Needless to say, the display color of the workpiece may also be changed in other ways.

Next, specific methods and the like for correcting the motion parameters, which was mentioned above, will be described with reference to the drawings.

2-1-1. Parameter correction process (1)

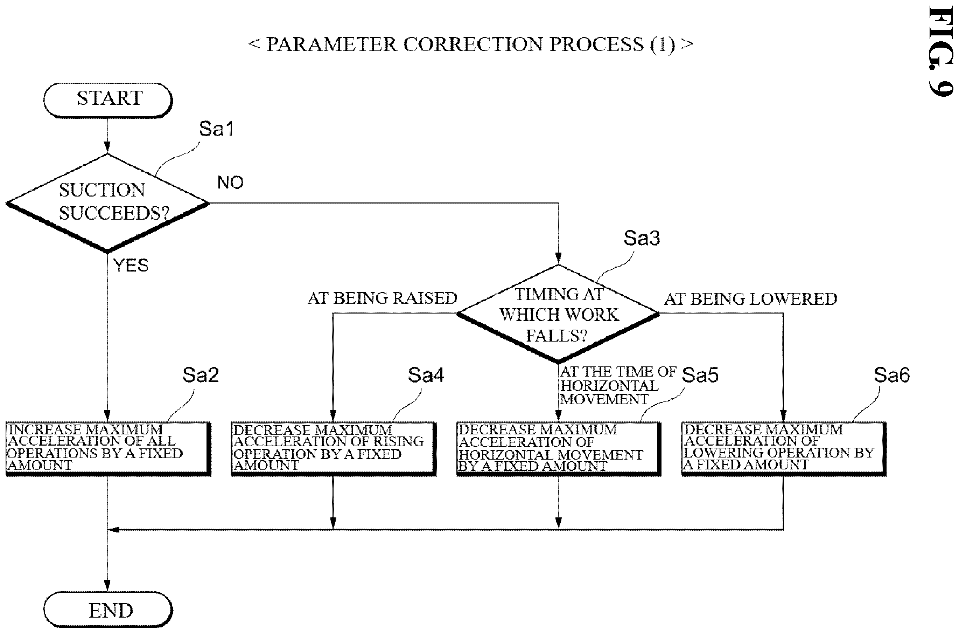

Fig. 9 is a flowchart showing a parameter correction process (1) performed by the motion parameter correction unit 180. First, the motion parameter correction unit 180 determines whether the workpiece has been successfully sucked (step Sa1). If the motion parameter correction unit 180 determines that the workpiece has been successfully sucked (YES in step Sa1), the motion parameter correction unit 180 increases the maximum acceleration Amax of all operations by a fixed amount to transport the workpiece more rapidly (step Sa2).

On the other hand, if the motion parameter correction unit 180 determines that the suction of the workpiece fails (NO in step Sa1), the motion parameter correction unit 180 determines the falling timing of the workpiece 14. In this parameter correction process (1), the motion parameter correction unit 180 determines that the suction of the workpiece fails if the workpiece has fallen, and determines the falling timing of the workpiece 14 (step Sa3). Instances in which it is regarded that the suction of the workpiece fails include not only a case where the workpiece 14 falls, but also a case where, even if the workpiece 14 does not fall, the oscillation amplitude of the workpiece 14 becomes larger than or equal to a certain value. The method for correcting the motion parameters under the assumption that the suction of the workpiece fails if the oscillation amplitude of the workpiece 14 is larger than or equal to a certain value will be described later. Accordingly, the description will be continued.

If the motion parameter correction unit (the correction receiving unit) 180 determines that the falling timing of the workpiece 14 is at the time of being raised, then, to prevent the falling of the workpiece 14, the motion parameter correction unit 180 decreases the maximum acceleration in the direction in which the suction pad moves, that is, in the rising direction by a fixed amount (step Sa3 to step Sa4), and ends the process.

On the other hand, if the motion parameter correction unit (the correction receiving unit) 180 determines that the falling timing of the workpiece 14 is at the time of horizontally moving, then, to prevent the falling of the workpiece 14, the motion parameter correction unit 180 decreases the maximum acceleration in the horizontal direction by a fixed amount (step Sa3 to step Sa5), and ends the process.

Furthermore, if the motion parameter correction unit (the correction receiving unit) 180 determines that the falling timing of the workpiece 14 is at the time of being lowered, then, to prevent the falling of the workpiece 14, the motion parameter correction unit 180 decreases the maximum acceleration in the lowering direction by a fixed amount (step Sa3 to step Sa6), and ends the process.

Application 1

Note, that in the above examples, the maximum acceleration is given as an example of a motion parameter corrected by the motion parameter correction unit (the correction receiving unit and the suction pad change receiving unit) 180. However, instead of the maximum acceleration, any of the following motion parameters (or any combination of them) may also be controlled.

Examples of other motion parameters: Maximum deceleration, maximum speed, jerk, acceleration time, deceleration time, suction pressure, suction time, shape of suction pad (general type, soft type, bellows type, etc.), material of the suction pad (nitrile butadiene rubber (NBR), silicon, etc.), suction position of the suction pad, diameter of the suction pad, the number of suction pads, and so on.

Application 2

Also, examples of the criteria for selecting the motion parameters to be controlled (the selection criteria of the motion parameters) include a time taken for transporting the workpiece 14, the tolerance for suction traces on the workpiece 14, or the like. If the tolerance of the suction trace on the workpiece 14 is large, for example, the suction pressure and the suction time are selected with priority as the motion parameters to be controlled. Also, if a time taken for transporting the workpiece 14 is long, the maximum speed and the acceleration time are selected with priority as the parameters to be controlled. Needless to say, the selection criteria of the motion parameters are not limited to these criteria. Other criteria may also be employed.

2-1-2. Parameter correction process (2)

In the above parameter correction process (1), the motion parameters are corrected under the assumption that the suction has failed if the workpiece 14 falls. On the other hand, in the parameter correction process (2), even if the workpiece 14 does not fall, the motion parameters are corrected under the assumption that the suction has failed if the oscillation amplitude is larger than or equal to a certain value.

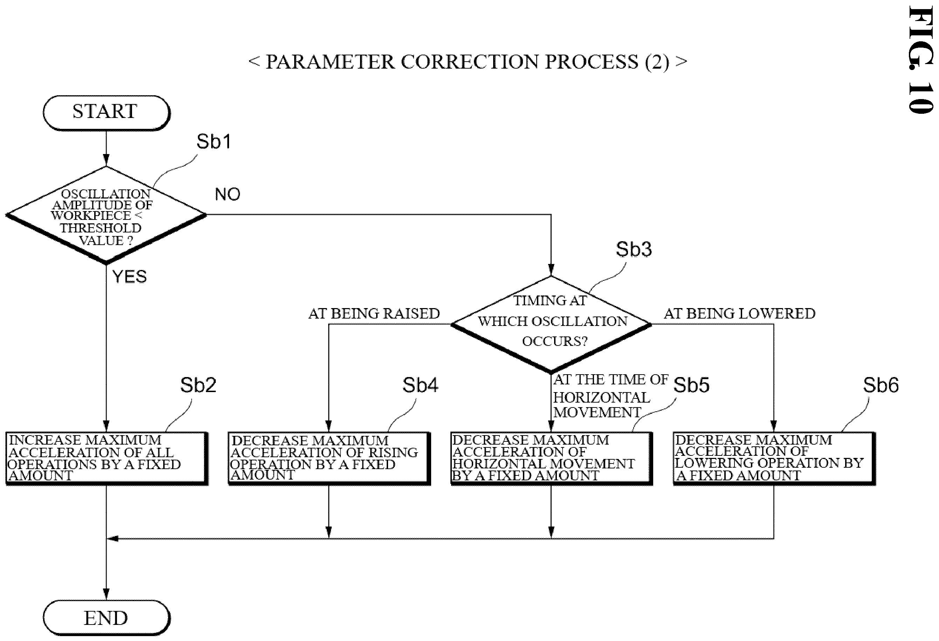

Fig. 10 is a flowchart showing a parameter correction process (2) performed by the motion parameter correction unit 180. First, the motion parameter correction unit 180 determines whether the oscillation amplitude of the workpiece 14 is lower than a threshold value Ath (step Sb1). If the motion parameter correction unit 180 determines that the oscillation amplitude of the workpiece is lower than the set threshold value Ath and the workpiece has been successfully sucked (YES in step Sa1), the motion parameter correction unit 180 increases the maximum acceleration Amax of all operations by a fixed amount to transport the workpiece more rapidly (step Sb2).

On the other hand, if the motion parameter correction unit 180 determines that the oscillation amplitude of the workpiece is larger than or equal to the set threshold value Ath (NO in step Sb1), the motion parameter correction unit 180 assumes that the suction of the workpiece has failed, and determines the timing at which the vibration having the oscillation amplitude larger than the threshold value Ath (hereinafter referred to as "abnormal vibration") occurred (step Sb3). Specifically, the motion parameter correction unit 180 determines whether the abnormal vibration occurs at the timing when the workpiece is being raised, at the timing when the workpiece moves horizontally, or at the timing when the workpiece is being lowered.

If the motion parameter correction unit 180 determines that the abnormal vibration occurs at the timing when the workpiece is being raised, then, to prevent the occurrence of the abnormal vibration, the motion parameter correction unit 180 reduces the maximum acceleration of the rising motion by a fixed amount (step Sb3 to step Sb4), and ends the process.

On the other hand, if the motion parameter correction unit 180 determines that the abnormal vibration occurs at the timing when the workpiece is horizontally moving, then, to prevent the occurrence of the abnormal vibration, the motion parameter correction unit 180 reduces the maximum acceleration of the horizontal motion by a fixed amount (step Sb3 to step Sb5), and ends the process.

Furthermore, if the motion parameter correction unit 180 determines that the abnormal vibration occurs at the timing when the workpiece is being lowered, then, to prevent the occurrence of the abnormal vibration, the motion parameter correction unit 180 reduces the maximum acceleration of the lowering motion by a fixed amount (step Sb3 to step Sb6), and ends the process.

Note, that as the application of the parameter correction process (2), it is needless to say that the above-mentioned applications 1 and 2 of the parameter correction process (1) may also be used.

2-2. Second functional configuration (in case where motion parameters are manually corrected)

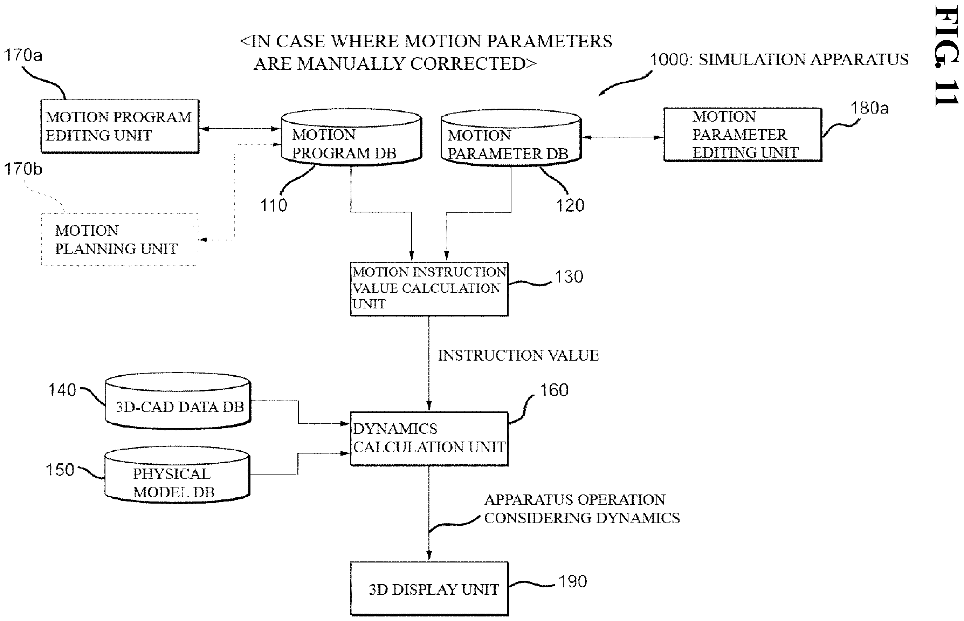

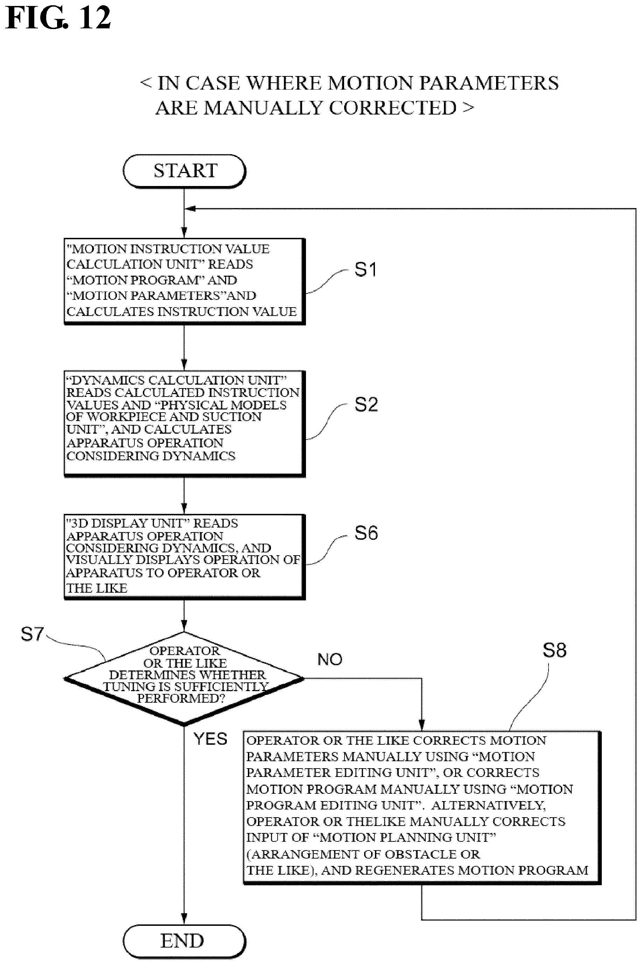

Here, Fig. 11 is a block diagram showing a second functional configuration according to the simulation apparatus 1000, and Fig. 12 is a flowchart showing the outline of the simulation operation performed by the simulation apparatus 1000. In the above first functional configuration shown in Fig. 2, the motion parameters of the pick-and-place apparatus are automatically corrected depending on the result of success or failure of the suction of the workpiece, whereas the second functional configuration shown in Fig. 11 is different in that the motion parameters of the pick-and-place apparatus are manually corrected depending on the result of success or failure of the suction of a workpiece. Note, that in Figs. 11 and 12, the units corresponding to those in Figs. 2 and 3 are denoted by the same reference numerals, and a detailed description thereof will be omitted.

As shown in Fig. 11, the simulation apparatus 1000 includes a motion program editing unit 170a (or a motion planning unit 170b) and a motion parameter editing unit 180a, in addition to the motion program DB 110, the motion parameter DB 120, the motion instruction value calculation unit 130, the 3D-CAD data DB 140, the physical model DB 150, the dynamics calculation unit 160, and the 3D display unit 190. An operator or the like inputs editing instructions such as a motion program, motion parameters, and obstacle arrangement information by operating operation buttons and the like (not shown) as appropriate.

The motion program editing unit 170a corrects the motion program registered in the motion program DB 110 in accordance with the editing instruction for the motion program, which is manually input by the operator or the like (see step S8 shown in Fig. 12). The motion planning unit 170b may also be provided, instead of the motion program editing unit 170a. The motion planning unit 170b automatically generates a motion program from the arrangement information between the pick-and-place apparatus and an obstacle. Specifically, the operator or the like manually corrects the arrangement information between the pick-and-place apparatus and the obstacle by operating the operation buttons and the operation panel as appropriate. Based on the corrected arrangement information between the pick-and-place apparatus and the obstacle, the motion planning unit 170b again generates the motion program automatically (see step S8 shown in Fig. 12).

The motion parameter editing unit 180a corrects the motion parameters registered in the motion parameter DB 120 in accordance with the editing instruction for the motion parameters, which is manually input by the operator or the like (see step S8 shown in Fig. 12).

Normally, the motion program is corrected if the motion program cannot be adjusted by correcting the motion parameters. Let us consider the case of a motion program in which the pick-and-place apparatus moves in an arc in order to avoid an obstacle, for example, where a workpiece falls due to centrifugal force and the suction of the workpiece continues to fail if merely correcting the motion parameters. In order to cope with such a case, it is conceivable that the motion program is corrected so as to avoid the obstacle by letting the pick-and-place apparatus move linearly. Of course, which one of the motion parameters and the motion program is preferentially corrected can be set or changed as appropriate, depending on the contents of the program or the like.

In view of the above, the operation when manually correcting the motion parameters will be briefly described in the following. First, when a command for transporting a workpiece is input into the pick-and-place apparatus that is to be simulated, the motion instruction value calculation unit 130 reads the motion program shown in Table 1 from the motion program DB 110, and also reads the motion parameters shown in Table 2 from the motion parameter DB 120 to calculate the operation instruction values (see step S1 shown in Fig. 12).

The dynamics calculation unit 160 reads the operation instruction values that are output from the motion instruction value calculation unit 130, and the physical models of the workpiece and the holding unit from the physical model DB 150, and calculates the apparatus operation considering the dynamics (see step S2 shown in Fig. 12).

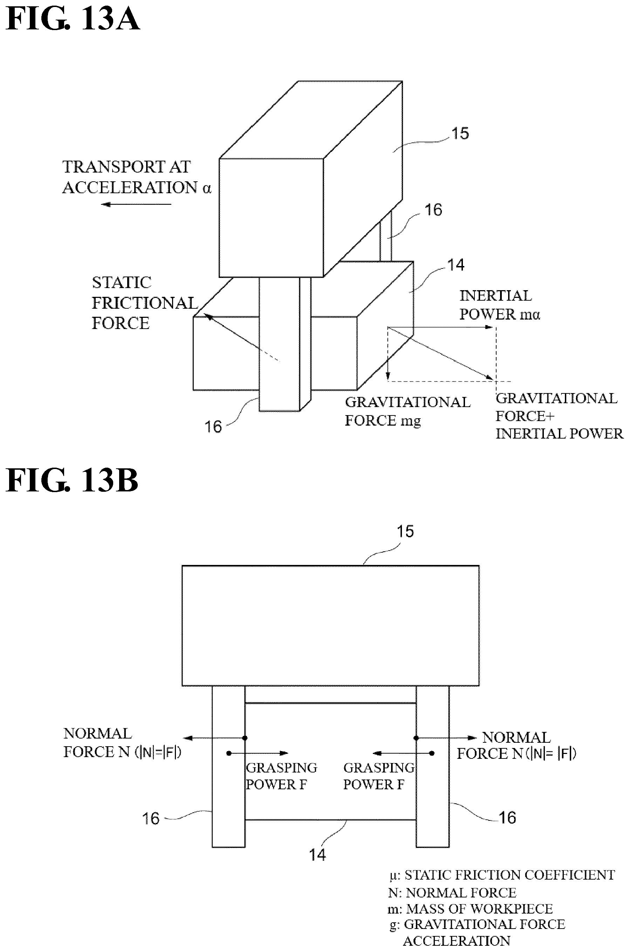

The 3D display unit 190 displays a 3D image of the recalculated apparatus operation considering the dynamics in the display unit such as the monitor (see step S6 shown in Fig. 13) to let the operator or the like recognize the operation simulation of the pick-and-place apparatus.

The operator or the like confirms the simulation image, determines whether the suction operation of the workpiece by the pick-and-place apparatus has been sufficiently adjusted (tuned), and performs an input operation indicating whether the adjustment has been sufficiently made (see step S7 shown in Fig. 12). If the operator or the like determines that the adjustment has not been made sufficiently, for example, due to the failed suction of the workpiece (NO on step S7 shown in Fig. 12), the process moves to step S8. The operators or the like manually corrects the motion parameters, the motion program, the arrangement information of the obstacle, and the like by operating the operation buttons or the like. If such an operation is made, the simulation apparatus 1000 returns to step S1, and continues the series of processes of steps S1, S2, S6, S7 and S8 that are described above.

On the other hand, if the operator or the like determines that the adjustment has been sufficiently made because of successful suction of the workpiece (YES in step S7 shown in Fig. 12), the operator or the like operates the operation buttons or the like and ends the manual correction process of the motion parameters.

As mentioned above, according to the present embodiment, the motion parameters, the motion program, and the like are automatically or manually corrected such that the workpieces can be sucked appropriately, by calculating the apparatus operation considering the dynamics using the operation instruction values of the pick-and-place apparatus and the physical models of the workpiece and the holding unit, and simulating the apparatus operation. In this manner, it is possible to easily and accurately simulate the operation of the pick-and-place apparatus. Also, because there is no need to use an actual machine, it is possible to eliminate concerns such as the occurrence of failures in the actual machine due to the adjustment of the operational parameters.

B. Others

First variation

In the above-described embodiment, a pick-and-place apparatus with a suction pad is simulated, but the pick-and-place apparatus may also include a chuck with claws for holding a workpiece instead of the suction pad. Note, that in the variation explained below, units corresponding to those in the above-mentioned embodiment are denoted by the same reference numerals, and a detailed description thereof will be omitted.

Figs 13A and 13B are drawings illustrating the physical models of a workpiece and a holding unit according to a first variation.

The holding unit (grasping-type holding unit) of the pick-and-place apparatus includes a chuck 15 with two claws 16 provided at the end portion of the arm.

As mentioned above, the physical models of the workpiece and the holding unit are registered in the physical model DB 150. In the example shown in Figs. 13A and 13B, the grasping power F of the chuck 15, a coefficient of static friction $\mu$, normal force N (=F), the mass of a workpiece m, the gravitational force acceleration g, acceleration $\alpha$ and the like are defined.

The dynamics calculation unit (the holding force calculation unit) 160 reads the operation instruction values that are output from the motion instruction value calculation unit 130, and the physical models of the workpiece and the holding unit from the physical model DB 150, and calculates the apparatus operation considering the dynamics.

The suction success/failure calculation unit (in this variation, a grasping success/failure calculation unit) 170 determines whether the workpiece has been successfully grasped by the chuck 15 based on the apparatus operation considering the dynamics that is supplied from the dynamics calculation unit 160, and outputs the determination result information representing the determination result to the motion parameter correction unit 180. In the example of the chuck 15 shown in Figs. 13A and 13B, as the condition for determining whether the workpiece has been successfully grasped, if the force obtained by adding gravitational force and inertial force is larger than the maximum static frictional force, that is, if the following equation (1) is satisfied, it is assumed that the workpiece falls and it is determined that the grasping of the workpiece fails.

$$|m\alpha + mg| > 2\mu N \cdots (1)$$

Note, that the condition for determining whether the workpiece has been successfully grasped is not limited to the above equation (1), and various conditions may also be employed. Also, the configuration of the chuck 15 is not limited to a configuration in which the chuck 15 includes two claws. A configuration may also be employed in which the chuck 15 includes a plurality of claws, such as three claws or four claws.

Second variation

In the above embodiment, the physical models shown in Fig. 5 are used. Also, a prediction model or the like is created using system identification, machine learning, or the like from the input and output data actually measured using the pick-and-place apparatus, and it may also be determined whether the workpiece falls using this prediction model. In the second variation shown below, it is determined whether a workpiece falls using an investigation result obtained by using an actual machine, instead of using physical models.

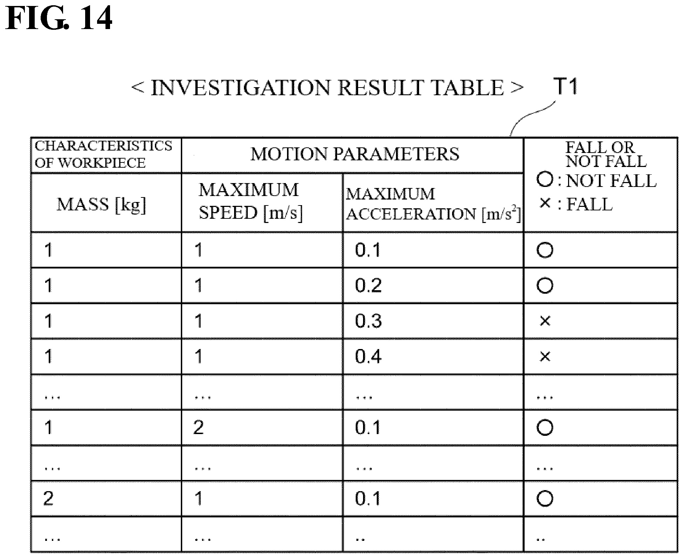

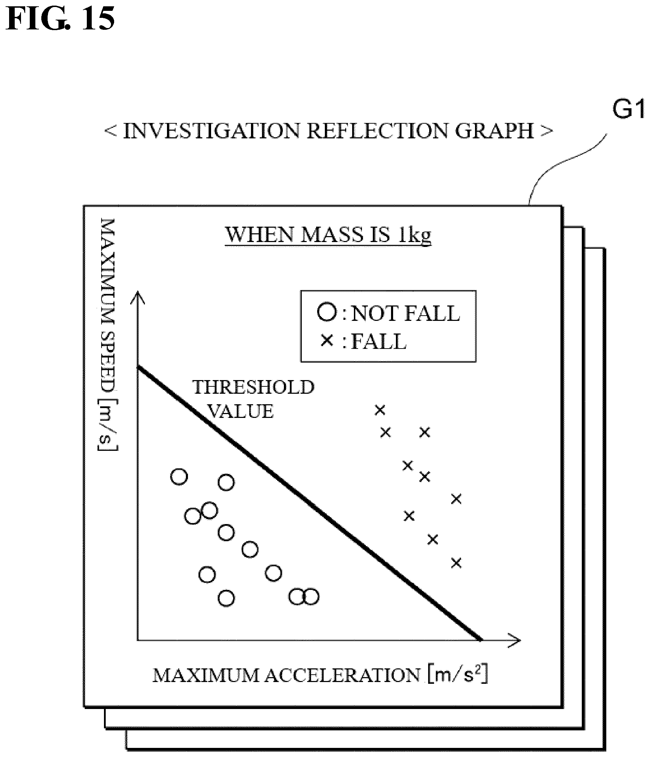

Fig. 14 is an investigation result table T1 illustrating the result of the investigation for determining whether a workpiece falls, which is preformed using the actual pick-and-place apparatus. Fig. 15 is an investigation reflection graph G1 in which, based on the investigation result table shown in Fig. 14, threshold values for determining whether the workpiece falls under each condition are set. As shown in Fig. 14, when the investigation is performed, it is confirmed whether the workpiece falls (that is, success or failure of holding a workpiece) by changing the characteristics of the workpiece such as the mass of the workpiece, and motion parameters such as the maximum acceleration. The operator or the like plots, on a graph, the results of investigation for determining whether the workpiece falls under each condition, and creates the investigation reflection graph (graph reflecting these investigations) G1, as shown in Fig. 15, in which threshold values (hereinafter referred to as "threshold reflecting the investigation") used for determining whether the workpiece falls under each set of conditions are set.

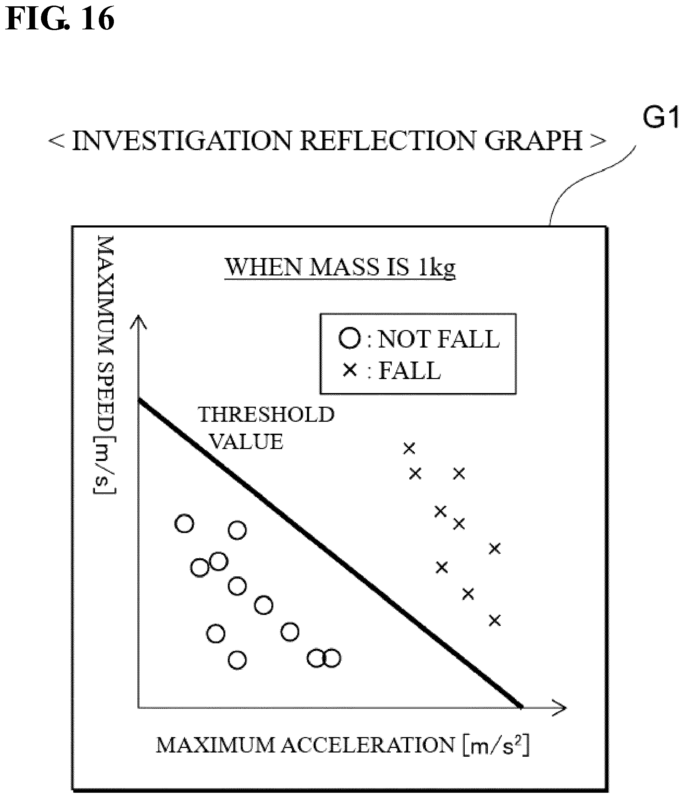

Fig. 16 is a drawing for explaining the operation in the case of simulating whether a workpiece falls using the investigation reflection graph G1.

The simulation apparatus 1000 plots, on the investigation reflection graph G1, the characteristics of the workpiece (e.g., the mass of the workpiece) and the values of the motion parameters (e.g., the maximum speed and the maximum acceleration) that are input by the operator or the like. In Fig. 16, the coordinate of the point plotted by black circle represents simulation conditions of the workpiece and the motion parameters, which are input by the operator or the like.

In the investigation reflection graph G1, if a plot is located in the area above the threshold reflecting the investigation, it is determined that a workpiece will fall. On the other hand, if a plot is present in the area below the threshold reflecting the investigation, it is determined that a workpiece will not fall. In the simulation condition input by the operator or the like, which is shown in Fig. 16, because the black circle is plotted in the area above the threshold reflecting the investigation, the simulation apparatus 1000 determines that a workpiece will fall. Based on the determination result, the simulation apparatus 1000 displays a 3D image representing that the workpiece falls in the display unit 1300 such as a liquid crystal panel. As mentioned above, it may also be determined whether a workpiece falls using the investigation result obtained by using an actual machine, without using physical models.

The simulation techniques according to the above embodiment and variations can be applied to various fields. These simulation techniques can be applied to various pick-and-place apparatuses used in various industrial fields such as food, mechanical parts, chemical products, and chemicals, fishery field, agriculture field, forestry field, service industry, and medical and health industry. Also, these simulation techniques are not limited to the application to a pick-and-place apparatus, and may also be applied to an assembly apparatus used for, for example, holding workpieces with an arm, transporting the workpieces to a predetermined position, and then assembling the workpieces.

Note, that in the present specification, the term "unit" does not mean merely a physical configuration, but also includes a case where the function of the "unit" is realized by software. Also, the function of one "unit" may also be realized by two or more physical configurations or apparatuses. On the other hand, the functions of two or more "units" or apparatuses may also be realized by one physical means or apparatus.

Additional Remark 1

A simulation apparatus comprising at least one hardware processor and configured to simulate whether a holding unit with which a robot is provided can hold an article, wherein
the hardware processor:
determines whether the holding unit can hold the article based on:

an operation instruction value of the holding unit that is calculated based on moving speed or acceleration of the holding unit and a moving path of the holding unit, and
the mass of the article.

Additional Remark 2

A simulation method for simulating whether a holding unit with which a robot is provided can hold an article by at least one or more hard processors,
the hardware processor executing:
a holding success/failure determination step of determining whether the holding unit can hold the article based on:

an operation instruction value of the holding unit that is calculated based on moving speed or acceleration of the holding unit and a moving path of the holding unit, and
the mass of the article.

Additional Remark 3

A robot comprising at least one hardware processor and being provided with a simulation function for simulating whether a holding unit can hold an article, wherein
the hardware processor:
determines whether the holding unit can hold the article based on:

an operation instruction value of the holding unit that is calculated based on moving speed or acceleration of the holding unit and a moving path of the holding unit, and
the mass of the article.

**Claims**

1.  A simulation apparatus configured to simulate whether an article can be held by a holding unit with which a robot is provided, the apparatus comprising:
    a holding success/failure determination unit configured to determine whether the holding unit can hold the article, based on:

    an operation instruction value of the holding unit that is calculated based on moving speed or acceleration of the holding unit and a moving path of the holding unit, and
    the mass of the article.

2.  The simulation apparatus according to claim 1 further comprising:

    an instruction value calculation unit configured to calculate an operation instruction value of the holding unit based on the moving speed or the acceleration of the holding unit and the moving path of the holding unit; and
    a holding force calculation unit configured to calculate, from the operation instruction value and the mass of the article, a holding force with which the holding unit holds the article when the holding unit operates in accordance with the operation instruction value,
    wherein the holding success/failure determination unit is configured to determine whether the holding unit can hold the article based on the holding force.

3.  The simulation apparatus according to claim 2, wherein
    the holding force calculation unit is configured to calculate the holding force with which the holding unit holds the article, considering a motion of rotation about the horizontal or vertical direction with respect to the transportation surface of the article.

4.  The simulation apparatus according to claim 2, wherein
    the holding force calculation unit is configured to calculate an oscillation amplitude of the article based on the operation instruction value and the mass of the article, and
    the holding success/failure determination unit is configured to determine, based on a result of comparison between the calculated oscillation amplitude of the article and a predetermined threshold value, whether the holding unit can hold the article.

5. The simulation apparatus according to claim 4 further comprising:
a first display unit configured to display the oscillation amplitude of the article.

6. The simulation apparatus according to claim 2 further comprising:

a second display unit configured to display an image simulating success or failure of holding of the article by the holding unit,
wherein the display color of the article that is displayed in the second display unit is changed based on the holding force with which the holding unit holds the article.

7. The simulation apparatus according to claim 2, wherein
the simulation apparatus is configured to receive a change of moving speed or acceleration of the holding unit, and
the holding success/failure determination unit is configured to determine again, based on the received moving speed or acceleration of the holding unit after the change, whether the holding unit can hold the article.

8. The simulation apparatus according to any one of claims 2 to 7, wherein
the holding unit is a suction pad that holds the article by suction.

9. The simulation apparatus according to claim 8, wherein
the holding force calculation unit is configured to calculate a holding force with which the holding unit holds the article, considering a suctional force with which the suction pad sucks the article and a normal force at a contact surface between the suction pad and the article.

10. The simulation apparatus according to claim 9, wherein
the holding success/failure determination unit is configured to determine that the article cannot be held when the normal force at the contact surface between the suction pad and the article becomes zero, and
the simulation apparatus further includes a correction receiving unit configured to receive a correction of the moving speed or the acceleration in the direction in which the suction pad operates at that time.

11. The simulation apparatus according to claim 9, wherein
the holding force calculation unit is configured to also calculate a suction frictional force generated between the suction pad and the article.

12. The simulation apparatus according to claim 9, wherein
the holding force calculation unit is configured to calculate the normal force also considering the ambient outside pressure in which the robot operates.

13. The simulation apparatus according to claim 9, wherein
the holding success/failure determination unit is configured to determine that the article cannot be held when the normal force at the contact surface between the suction pad and the article becomes zero, and
the simulation apparatus further includes a suction pad change receiving unit configured to receive a change of the diameter of the suction pad or the number of the suction pads.

14. The simulation apparatus according to any one of claims 2 to 7, wherein
the holding unit is a grasping-type holding unit configured to hold the article with claws.

15. The simulation apparatus according to claim 14, wherein
the holding force calculation unit is configured to calculate a force with which the holding unit holds the article, considering grasping power with which the article is grasped by the claws and a frictional force at a contact surface between the claws and the article.

16. A simulation method for simulating whether a holding unit with which a robot is provided can hold an article, the method comprising:
a holding success/failure determination step of determining whether the holding unit can hold the article based on:

an operation instruction value of the holding unit that is calculated based on moving speed or acceleration of the holding unit and a moving path of the holding unit, and
the mass of the article.

**17.** A simulation program for causing a computer to execute simulation for determining whether a holding unit with which a robot is provided can hold an article, the program causing the computer to execute:
a holding success/failure determination step of determining whether the holding unit can hold the article based on:

an operation instruction value of the holding unit that is calculated based on moving speed or acceleration of the holding unit and a moving path of the holding unit, and
the mass of the article.

**18.** A robot provided with a simulation function for simulating whether an article can be held by a holding unit, the robot comprising:
a holding success/failure determination unit configured to determine whether the holding unit can hold the article, based on:

an operation instruction value of the holding unit that is calculated based on moving speed or acceleration of the holding unit and a moving path of the holding unit, and
the mass of the article.

FIG. 1

EP 3 563 984 A1

1000: SIMULATION APPARATUS

CONTROL UNIT

1110    1120    1130

1100

| CPU | ROM | RAM |

STORAGE UNIT — 1400

KEY BOARD    MOUSE

1210    1220

1200    INPUT UNIT

DISPLAY UNIT — 1300

OPTICAL DISC DRIVING UNIT — 1500

COMMUNI-CATION IF — 1600

FIG. 2

< IN CASE WHERE MOTION PARAMETERS ARE AUTOMATICALLY CORRECTED >

1000: SIMULATION APPARATUS

MOTION PROGRAM DB — 110

MOTION PARAMETER DB — 120

CORRECTED MOTION PARAMETERS

MOTION INSTRUCTION VALUE CALCULATION UNIT — 130

MOTION PARAMETER CORRECTION UNIT — 180

INSTRUCTION VALUE

SUCCESS OR FAILURE OF SUCTION OF WORKPIECE

3D-CAD DATA DB — 140

PHYSICAL MODEL DB — 150

DYNAMICS CALCULATION UNIT — 160

SUCTION SUCCESS/ FAILURE CALCULATION UNIT — 170

APPARATUS OPERATION CONSIDERING DYNAMICS

3D DISPLAY UNIT — 190

EP 3 563 984 A1

# FIG. 3

< IN CASE WHERE MOTION PARAMETERS
ARE AUTOMATICALLY CORRECTED >

```
                    START

S1    "MOTION INSTRUCTION VALUE
      CALCULATION UNIT" READS
      "MOTION PROGRAM" AND "MOTION
      PARAMETERS" AND CALCULATES
      INSTRUCTION VALUES

S2    "DYNAMICS CALCULATION UNIT" READS
      CALCULATED INSTRUCTION VALUES AND
      "PHYSICAL MODELS OF WORKPIECE AND
      SUCTION UNIT", AND CALCULATES
      APPARATUS OPERATION CONSIDERING
      DYNAMICS

S3    "SUCTION SUCCESS/FAILURE
      CALCULATION UNIT" READS APPARATUS
      OPERATION CONSIDERING DYNAMICS, AND
      DETERMINES WHETHER SUCCESS OR
      FAILURE OF SUCTION OF WORKPIECE

S4    "MOTION PARAMETERS"
      ARE CORRECTED BY "MOTION
      PARAMETER CORRECTION UNIT"

S5    CALCULATE AGAIN INSTRUCTION VALUES
      FROM CORRECTED MOTION PARAMETERS,
      AND RECALCULATE APPARATUS
      OPERATION CONSIDERING DYNAMICS

S6    "3D DISPLAY UNIT" READS APPARATUS
      OPERATION CONSIDERING DYNAMICS, AND
      VISUALLY DISPLAYS OPERATION OF
      APPARATUS TO OPERATOR OR THE LIKE

S7    OPERATOR OR
      THE LIKE DETERMINES                    NO
      WHETHER TUNING IS
      SUFFICIENTLY
      PERFORMED?

               YES

               END
```

# FIG. 4

## FIG. 5

9
MOVEMENT OF ARM
10
11
12
ROTATION OF WORKPIECE
13
14
MOVEMENT OF CONTENTS

PHYSICAL
COEFFICIENTS
OF SUCTION PAD

ROTATIONAL
DAMPING
COEFFICIENT $C_{pad}$

MASS $m_{pad}$

ROTATIONAL
ELASTIC COEFFICIENT $K_{pad}$

PHYSICAL
COEFFICIENTS
OF CONTENTS

DAMPING
COEFFICIENT $C_{content}$

MASS $m_{content}$

ELASTIC
COEFFICIENT $k_{content}$

# FIG. 6

z

y

**9**

ACCELERATION
OF ARM

**11**

**14**

F: SUCTIONAL
POWER [N]
ma: INERTIAL FORCE [N]
mg: GRAVITATIONAL
FORCE [N]
fn: NORMAL FORCE [N]
μfn: SUCTION
FRICTIONAL FORCE [N]

F

μfn1

fn1

μfn2

fn2

CENTER OF
GRAVITY OF WORKPIECE

ma

mg

ROTATION OF
WORKPIECE

WORKPIECE
CANNOT BE SUCKED
IF ONE OF fn1 AND fn2
BECOMES ZERO
→
WORKPIECE FALLS

# FIG. 7

9

11

OSCILLATION
AMPLITUDE θ
OF WORKPIECE

14

ANGULAR VELOCITY ω
OF ROTATION OF WORKPIECE

# FIG. 8A

< IN CASE WHERE WORKPIECE IS
SUCCESSFULLY SUCKED >

# FIG. 8B

< IN CASE WHERE SUCTION OF
WORKPIECE FAILS >

FIG. 9

< PARAMETER CORRECTION PROCESS (1) >

EP 3 563 984 A1

# FIG. 10

< PARAMETER CORRECTION PROCESS (2) >

START

Sb1
OSCILLATION AMPLITUDE OF WORKPIECE < THRESHOLD VALUE ?

NO

YES

Sb3
TIMING AT WHICH OSCILLATION OCCURS?

AT BEING RAISED

AT THE TIME OF HORIZONTAL MOVEMENT

AT BEING LOWERED

Sb4
DECREASE MAXIMUM ACCELERATION OF RISING OPERATION BY A FIXED AMOUNT

Sb5
DECREASE MAXIMUM ACCELERATION OF HORIZONTAL MOVEMENT BY A FIXED AMOUNT

Sb6
DECREASE MAXIMUM ACCELERATION OF LOWERING OPERATION BY A FIXED AMOUNT

Sb2
INCREASE MAXIMUM ACCELERATION OF ALL OPERATIONS BY A FIXED AMOUNT

END

FIG. 11

<IN CASE WHERE MOTION PARAMETERS ARE MANUALLY CORRECTED>

1000: SIMULATION APPARATUS

170a — MOTION PROGRAM EDITING UNIT

170b — MOTION PLANNING UNIT

MOTION PROGRAM DB — 110

MOTION PARAMETER DB — 120

180a — MOTION PARAMETER EDITING UNIT

MOTION INSTRUCTION VALUE CALCULATION UNIT — 130

INSTRUCTION VALUE

140 — 3D-CAD DATA DB

150 — PHYSICAL MODEL DB

DYNAMICS CALCULATION UNIT — 160

APPARATUS OPERATION CONSIDERING DYNAMICS

3D DISPLAY UNIT — 190

EP 3 563 984 A1

# FIG. 12

< IN CASE WHERE MOTION PARAMETERS
ARE MANUALLY CORRECTED >

START

"MOTION INSTRUCTION VALUE CALCULATION UNIT" READS "MOTION PROGRAM" AND "MOTION PARAMETERS"AND CALCULATES INSTRUCTION VALUE — S1

"DYNAMICS CALCULATION UNIT" READS CALCULATED INSTRUCTION VALUES AND "PHYSICAL MODELS OF WORKPIECE AND SUCTION UNIT", AND CALCULATES APPARATUS OPERATION CONSIDERING DYNAMICS — S2

"3D DISPLAY UNIT" READS APPARATUS OPERATION CONSIDERING DYNAMICS, AND VISUALLY DISPLAYS OPERATION OF APPARATUS TO OPERATOR OR THE LIKE — S6

S7 — OPERATOR OR THE LIKE DETERMINES WHETHER TUNING IS SUFFICIENTLY PERFORMED?

NO

S8

YES

OPERATOR OR THE LIKE CORRECTS MOTION PARAMETERS MANUALLY USING "MOTION PARAMETER EDITING UNIT", OR CORRECTS MOTION PROGRAM MANUALLY USING "MOTION PROGRAM EDITING UNIT". ALTERNATIVELY, OPERATOR OR THELIKE MANUALLY CORRECTS INPUT OF "MOTION PLANNING UNIT" (ARRANGEMENT OF OBSTACLE OR THE LIKE), AND REGENERATES MOTION PROGRAM

END

# FIG. 13A

TRANSPORT AT
ACCELERATION α

15

16

14

STATIC
FRICTIONAL
FORCE

INERTIAL
POWER mα

16

GRAVITATIONAL
FORCE mg

GRAVITATIONAL
FORCE+
INERTIAL POWER

# FIG. 13B

15

NORMAL
FORCE N (|N|=|F|)

GRASPING
POWER F

GRASPING
POWER F

NORMAL
FORCE N (|N|= |F|)

16

16

14

μ: STATIC FRICTION COEFFICIENT
N: NORMAL FORCE
m: MASS OF WORKPIECE
g: GRAVITATIONAL FORCE
    ACCELERATION

# FIG. 14

< INVESTIGATION RESULT TABLE > T1

| CHARACTERISTICS OF WORKPIECE | MOTION PARAMETERS | | FALL OR NOT FALL |
|---|---|---|---|
| MASS [kg] | MAXIMUM SPEED [m/s] | MAXIMUM ACCELERATION [m/s$^2$] | O : NOT FALL ✕ : FALL |
| 1 | 1 | 0.1 | O |
| 1 | 1 | 0.2 | O |
| 1 | 1 | 0.3 | ✕ |
| 1 | 1 | 0.4 | ✕ |
| ... | ... | ... | ... |
| 1 | 2 | 0.1 | O |
| ... | ... | ... | ... |
| 2 | 1 | 0.1 | O |
| ... | ... | .. | .. |

# FIG. 15

< INVESTIGATION REFLECTION GRAPH >   G1

# FIG. 16

< INVESTIGATION REFLECTION GRAPH >  G1

WHEN MASS IS 1kg

○ : NOT FALL
× : FALL

MAXIMUM SPEED [m/s]

THRESHOLD VALUE

MAXIMUM ACCELERATION $[\mathrm{m/s^2}]$

## INTERNATIONAL SEARCH REPORT

| | International application No. |
|---|---|
| | PCT/JP2017/009600 |

**A. CLASSIFICATION OF SUBJECT MATTER**
*B25J9/22*(2006.01)i, *B25J15/06*(2006.01)i

According to International Patent Classification (IPC) or to both national classification and IPC

**B. FIELDS SEARCHED**

Minimum documentation searched (classification system followed by classification symbols)
B25J9/22, B25J15/06

Documentation searched other than minimum documentation to the extent that such documents are included in the fields searched
Jitsuyo Shinan Koho          1922–1996   Jitsuyo Shinan Toroku Koho   1996–2017
Kokai Jitsuyo Shinan Koho    1971–2017   Toroku Jitsuyo Shinan Koho   1994–2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | US 9393693 B1 (GOOGLE INC.),<br>19 July 2016 (19.07.2016),<br>column 3, line 31 to column 20, line 67; fig. 1<br>to 7<br>(Family: none) | 1,16-18<br>2-15 |
| Y | JP 5-324022 A (Fanuc Ltd.),<br>07 December 1993 (07.12.1993),<br>paragraphs [0010] to [0019]; fig. 1 to 3<br>(Family: none) | 1,16-18 |
| A | JP 2016-49607 A (Canon Inc.),<br>11 April 2016 (11.04.2016),<br>paragraphs [0020] to [0025]; fig. 1 to 3<br>(Family: none) | 1,16-18 |

☒ Further documents are listed in the continuation of Box C.          ☐ See patent family annex.

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 17 May 2017 (17.05.17) | 30 May 2017 (30.05.17) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
|---|---|

Form PCT/ISA/210 (second sheet) (January 2015)

**INTERNATIONAL SEARCH REPORT**

International application No.

PCT/JP2017/009600

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2015-100866 A (Mitsubishi Electric Corp.), 04 June 2015 (04.06.2015), entire text; all drawings (Family: none) | 1-15 |
| A | WO 2012/066819 A1 (Mitsubishi Electric Corp.), 24 May 2012 (24.05.2012), entire text; all drawings & US 2013/0211593 A1 entire text; all drawings & JP 5558585 B2 & DE 112011103794 T5 & CN 103221188 A & KR 10-2013-0102080 A | 1-15 |
| A | JP 2010-264559 A (Seiko Epson Corp.), 25 November 2010 (25.11.2010), entire text; all drawings (Family: none) | 1-15 |
| A | JP 2013-163247 A (Seiko Epson Corp.), 22 August 2013 (22.08.2013), entire text; all drawings (Family: none) | 1-15 |
| A | JP 7-256578 A (Hitachi, Ltd.), 09 October 1995 (09.10.1995), entire text; all drawings (Family: none) | 4-5 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016255408 A
- JP H07256578 A